# EUROPEAN PATENT APPLICATION

(11) **EP 3 712 958 A1**
(43) Date of publication of application: **23.09.2020**
(21) Application number: 17931766.4
(22) Date of filing: 13.11.2017
(51) Int. Cl.: H01L 29/78, H01L 29/12

(54) **WIDE GAP SEMICONDUCTOR DEVICE**

(71) Applicant: Shindengen Electric Manufacturing Co., Ltd., Tokyo 100-0004 (JP)
(72) Inventor: NAKAMURA Shunichi, Hanno-shi Saitama 357-8585 (JP)
(74) Representative: AWA Sweden AB
(86) International application number: PCT/JP2017/040675
(87) International publication number: WO 2019/092870

(57) **Abstract**

A wide gap semiconductor device has: a drift layer 12 being a first conductivity type; a well region 20 being a second conductivity type and provided in the drift layer 12; a source region 31 provided in the well region 20; a gate insulating film 60 provided on the drift layer 12 and the well region 20; a field insulating film 62 provided between a gate insulating film 60 and the well region 20; a gate electrode 125 provided on the gate insulating film 60; and a gate pad 120 electrically connected to the gate electrode 125. The field insulating film 62 has a recessed part extending in a plane direction. The well region 20 has a well contact region 21 electrically connected to a source pad 110 provided in the recessed part.

## Description

### Technical Field

The present invention relates to a wide gap semiconductor device having a drift layer of a first conductivity type, a well region of a second conductivity type provided in the drift layer, and a source region provided in the well region.

### Background Art

It is known that in a vertical power switching device, when a gate electrode such as polysilicon is connected to a gate pad, the gate electrode and a gate insulating film are pulled up on a step part formed by a field insulating film provided in a peripheral part, and the gate electrode is connected to the gate pad.

JP H2-156572 A discloses that in a silicon-insulated gate bipolar transistor, a gate insulating film is broken by concentration of an on-state current, an off-state electric field, avalanche current during an avalanche, and the like. JP H11-074524 A proposes that the peripheral part of a silicon carbide (SiC) metal-oxide-semiconductor field-effect transistor (MOSFET) is made to be a p-type. It is considered that with this aspect, it is possible to avoid concentration of the on-state current and concentration of the off-state electric field state. However, a problem that the gate insulating film is broken during switching has not been solved.

Studies conducted by the inventor have found that in the case of a wide gap semiconductor material such as silicon carbide, contact resistance to a second conductivity type such as a p-type may be high, and when a displacement current that charges a pn junction flows during switching, the potential of an entire well of the second conductivity type in a peripheral part increases, and an electric field tends to concentrate in a step part mentioned above due to a three-dimensional shape of the step part. When the electric field concentrates in this manner, an excessive electric field may be applied to the gate insulating film and the gate insulating film may be broken.

### Summary of Invention

### Technical Problem

The present invention provides a semiconductor device that can suppress concentration of an electric field in a pulled up gate insulating film even in a case where a configuration in which a gate insulating film is pulled up on a field insulating film is adopted.

### Solution to Problem

### [Concept 1]

A wide gap semiconductor device may comprise:
a drift layer being a first conductivity type;
a well region being a second conductivity type and provided in the drift layer;
a source region provided in the well region;
a gate insulating film provided on the drift layer and the well region;
a gate electrode provided on the gate insulating film;
a gate pad electrically connected to the gate electrode; and
a field insulating film provided between a gate connection region, where the gate electrode and the gate pad are connected, and the well region, wherein
the field insulating film has a recessed part extending in a plane direction, and
the well region has a well contact region electrically connected to a source pad provided in the recessed part.

### [Concept 2]

In the wide gap semiconductor device according to concept 1,
the well contact region may extend at a distance equal to or longer than a propagation length from a first boundary part in a side of the source region of the field insulating film to a side opposite to the source region.

### [Concept 3]

In the wide gap semiconductor device according to concept 1 or 2,
the gate electrode may extend to a side opposite to the source region further than a first boundary part in a side of the source region of the field insulating film, and
the gate electrode and the gate pad may be electrically connected to each other via a gate contact hole, provided in the side opposite to the source region than the first boundary part, in an interlayer insulating film.

### [Concept 4]

In the wide gap semiconductor device according to concept 3,
a peripheral slit reaching the drift layer may be provided in the well region and in a side of the source region than a gate contact hole in the plane direction.

### [Concept 5]

In the wide gap semiconductor device according to concept 4,
the peripheral slit may have a first peripheral slit extending along a first boundary part in the plane direction, and a second peripheral slit provided at an end of the first peripheral slit and extending in a direction orthogonal to the first boundary part in the plane direction.

### [Concept 6]

In the wide gap semiconductor device according to any one of concepts 3 to 5,
the well contact region may extend to the side opposite to the source region further than an end of the gate electrode in the side opposite to the source region.

### [Concept 7]

In the wide gap semiconductor device according to concept 6,
the well contact region may extend to the side opposite to the source region at a distance equal to or longer than a propagation length from the end of the gate electrode in the side opposite to the source region.

### [Concept 8]

In the wide gap semiconductor device according to concept 6 or 7,
an inner slit reaching the drift layer may be provided in the well region and in a side opposite to the source region than the gate electrode in the plane direction.

### [Concept 9]

In the wide gap semiconductor device according to concept 8, the inner slit may have a second inner slit extending to the side opposite to the source region at a distance equal to or longer than a propagation length from the end of the gate electrode in the side opposite to the source region.

### Advantageous Effects of Invention

In the present invention, the field insulating film has a recessed part extending in a plane direction, and a well region has a well contact region electrically connected to a source pad provided in the recessed part. By adopting such a configuration, the electric field can be suppressed from being concentrated on the gate insulating film pulled up on the field insulating film.

### Brief Description of Drawings

Fig. 1 is a plan view of a semiconductor device that can be used in a first embodiment of the present invention.
Fig. 2 is a cross-sectional view of the semiconductor device taken along II-II cross section in Fig. 1.
Fig. 3 is a cross-sectional view of the semiconductor device having a region including a source region taken along a straight line orthogonal to Fig. 2.
Fig. 4 is a plan view of a semiconductor device that can be used in a second embodiment of the present invention.
Fig. 5 is a cross-sectional view of the semiconductor device taken along V-V cross section in Fig. 4.
Fig. 6 is a plan view of a semiconductor device that can be used in a third embodiment of the present invention.
Fig. 7 is a cross-sectional view of the semiconductor device taken along VII-VII cross section in Fig. 6.
Fig. 8 is a plan view of a semiconductor device that can be used in a fourth embodiment of the present invention.
Fig. 9 is a cross-sectional view of the semiconductor device taken along IX-IX cross section in Fig. 8.

### Description of Embodiments

### First Embodiment

### <<Configuration>>

In the present embodiment, description will be given using a vertical MOSFET as an example. In the present embodiment, a first conductivity type is described as an n-type, and a second conductivity type is described as a p-type. However, the present embodiment is not limited to such an aspect, and the first conductivity type may be the p-type, and the second conductivity type may be the n-type. Additionally, in the present embodiment, description will be given using silicon carbide as a wide gap semiconductor. However, the present embodiment is not limited to such an aspect, and gallium nitride or the like may be used as the wide gap semiconductor.

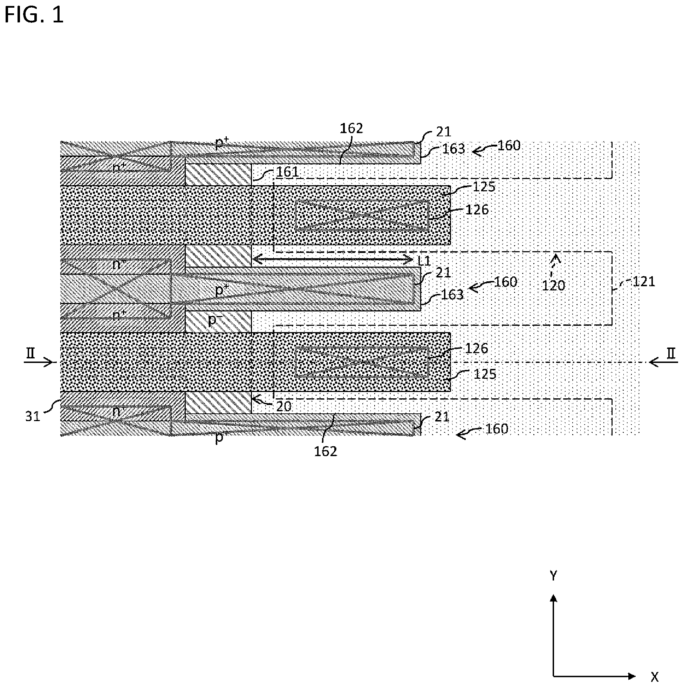

In the present embodiment, an in-plane direction including an X direction and a Y direction in Fig. 1 is referred to as a plane direction. A Z direction orthogonal to the X direction and the Y direction is a thickness direction of the semiconductor device, and is also referred to as an up-and-down direction.

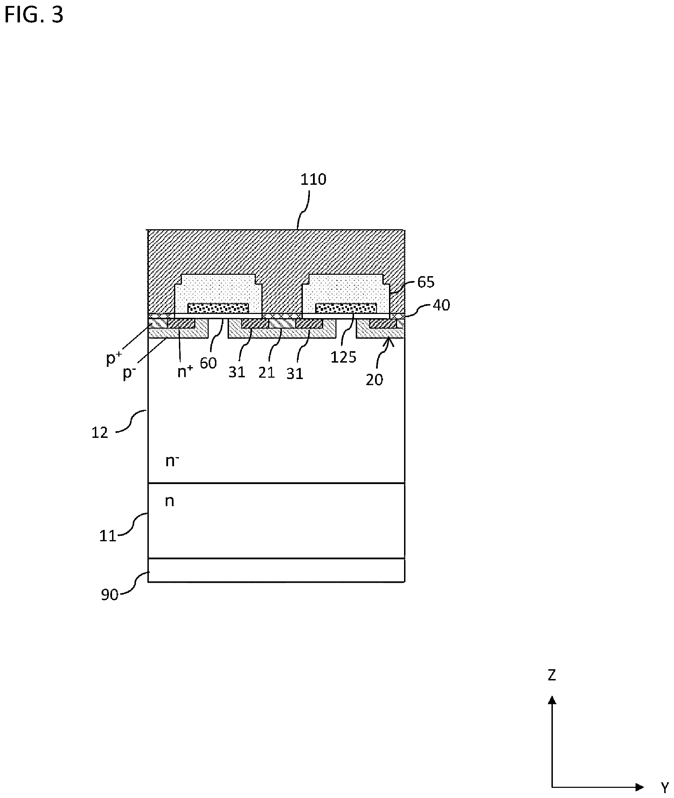

As shown in Fig. 3, the wide gap semiconductor device of the present embodiment may have a silicon carbide semiconductor substrate 11 of the n-type, a drift layer 12 provided on a first main surface (upper surface) of the silicon carbide semiconductor substrate 11 and using a n-type silicon carbide material, a well region 20 of of the p-type and provided in the drift layer 12, and a source region 31 of the n-type and provided in the well region 20. The well region 20 is formed, for example, by implanting a p-type impurity into the drift layer 12, and the source region 31 may be formed, for example, by implanting an n-type impurity into the well region 20. A drain electrode 90 may be provided on a second main surface (lower surface) of the silicon carbide semiconductor substrate 11. As the drain electrode 90, for example, titanium, aluminum, nickel may be used. An impurity concentration in the drift layer 12 of the present embodiment is, for example, 1 × 10¹⁴ to 4 × 10¹⁶ cm⁻³, and an impurity concentration in the silicon carbide semiconductor substrate 11 is, for example, 1 × 10¹⁸ to 3 × 10¹⁹ cm⁻³, and an impurity concentration in the source region 31, for example, 1 × 10¹⁹ to 1 × 10²¹ cm⁻³.

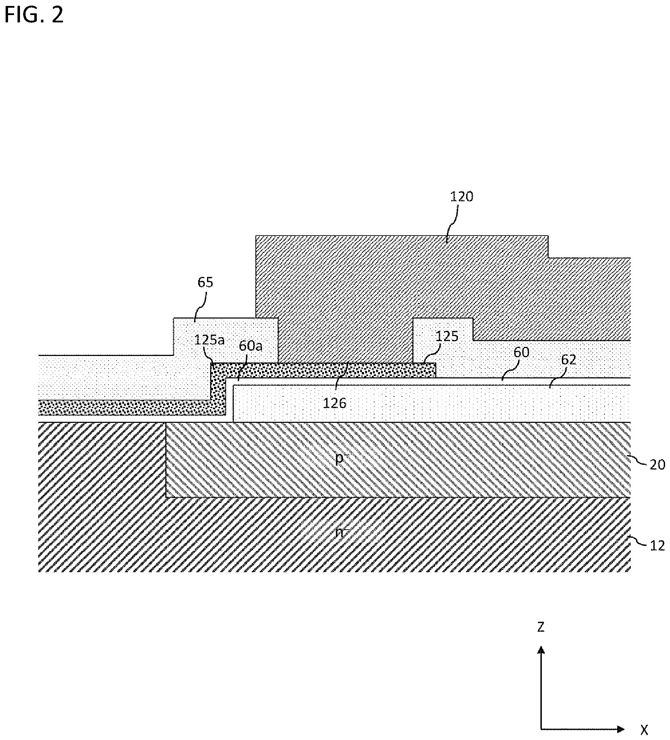

As shown in Fig. 2, the wide gap semiconductor device may have a gate insulating film 60 provided on the drift layer 12 and the well region 20, a field insulating film 62 provided between the gate insulating film 60 and the well region 20, a gate electrode 125 provided on the gate insulating film 60, and a gate pad 120 electrically connected to the gate electrode 125. A withstand voltage structure may be provided outside the periphery of a region used as a cell.

As shown in Fig. 2, the gate insulating film 60 is provided on an upper surface of the field insulating film 62, and the gate insulating film 60 may form a gate insulating film step part 60a at a peripheral part of the field insulating film 62. The gate insulating film step part 60a is formed by the gate electrode 125 riding on the field insulating film 62 at a first boundary part 161 (see Fig. 1) to be described later. The gate electrode 125 is provided on an upper surface of the gate insulating film 60, and the gate electrode 125 may be provided also with a gate electrode step part 125a.

As shown in Fig. 1, the field insulating film 62 may have a field insulating film recessed part 160 extending in the plane direction. The field insulating film 62 may have the first boundary part 161 on a side of the source region 31, a second boundary part 162 extending in a direction orthogonal to the first boundary part 161 (X direction), and a third boundary part 163 extending from an end of the second boundary part 162 in parallel to the first boundary part 161 (Y direction). In a configuration shown in Fig. 1, the field insulating film recessed part 160 is formed by the second boundary part 162 and the third boundary part 163.

The well region 20 may have a well contact region 21 electrically connected to a source pad 110 (see Fig. 3) provided in field insulating film recessed part 160. A metal layer 40 made of nickel, titanium, or an alloy containing nickel or titanium may be provided between the source region 31 and the source pad 110 and between the well contact region 21 and the source pad 110. Note that, in the present embodiment, as described above, the plane direction refers to a direction orthogonal to the thickness direction, and refers to the in-plane direction including the X direction and the Y direction in Fig. 1. The well contact region 21 has a high concentration of a p-type impurity and may be a high concentration region (p⁺ region). The well region 20 other than the well contact region 21 has a low concentration of the p-type impurity and may be a low concentration region (p⁻ region). An impurity concentration in the high concentration region of the p-type (p⁺ region) of the present embodiment is, for example, 2 × 10¹⁹ to 1 × 10²¹ cm⁻³, and an impurity concentration in the low concentration region of the p-type (p⁻ region) is, for example, 5 × 10¹⁶ to 1 × 10¹⁹ cm⁻³.

The drift layer 12 shown in Fig. 3 may be formed on the first main surface of the silicon carbide semiconductor substrate 11 by a chemical vapor deposition (CVD) method or the like. An n-type impurity concentration in the drift layer 12 may be lower than an n-type impurity concentration in the silicon carbide semiconductor substrate 11, and as shown in Fig. 3, the drift layer 12 becomes a low concentration region (n⁻), the silicon carbide semiconductor substrate 11 may be a region (n) having a higher concentration than a concentration in the drift layer 12. Note that, for example, N or P or the like can be used as the n-type impurity, and Al or B or the like can be used as the p-type impurity.

The gate pad 120 shown in Fig. 2 is formed of, for example, metal such as Al, and the gate electrode 125 may be formed of, for example, polysilicon. An interlayer insulating film 65 may be formed on an upper surface of the gate electrode 125 and the like. The gate electrode 125 may be formed by the CVD method, a photolithography technique, or the like. The interlayer insulating film 65 may be formed by the CVD method or the like, and may be formed of, for example, silicon dioxide.

As shown in Fig. 3, a depth of the well region 20 is a depth such that the bottom surface of the well region 20 is positioned at a position higher than the bottom surface of the drift layer 12, and the well region 20 may be provided in the drift layer 12. Additionally, a depth of the source region 31 is a depth such that the bottom surface of the source region 31 is positioned at a position higher than the bottom surface of the well region 20, and the source region 31 may be formed in the well region 20. Additionally, a depth of the well contact region 21 may be a depth such that the bottom surface of the well contact region 21 is positioned at a position higher than the bottom surface of the well region 20 other than the well contact region 21.

As shown in Fig. 1, the well contact region 21 extends linearly in the plane direction, and may extend at a distance equal to or longer than a propagation length from the first boundary part 161 in the side of the source region 31 of the n-type of the field insulating film 62 to a side opposite to the source region 31. More specifically, in Fig. 1, the well contact region 21 extends rightward (along the X direction) at a first distance L1 from the first boundary part 161 in the side of the source region 31 of the n-type that is the left end of the field insulating film 62, and the first distance L1 may be a distance equal to or longer than the propagation length.

As shown in Fig. 1, the gate pad 120 is not provided above the well contact region 21, and a gate pad recessed part 121 may be provided in the plane direction in the gate electrode 125 while corresponding to the field insulating film recessed part 160 of the field insulating film 62. The gate pad recessed part 121 is larger than the field insulating film recessed part 160, and when viewed from above (when the paper surface of Fig. 1 is viewed from the front side of the paper surface), the field insulating film recessed part 160 may be provided in the gate pad recessed part 121. Additionally, when viewed from above, the well contact region 21 may be provided in the field insulating film recessed part 160.

When viewed from above, the gate pad 120 formed of Al or the like between the gate pad recessed parts 121 may be connected to the gate electrode 125 formed of polysilicon or the like to form a gate connection region 126. As shown in Fig. 2, the gate connection region 126 is formed by the gate electrode 125 and the gate pad 120 contacting each other via a gate contact hole provided in the interlayer insulating film 65.

A plurality of field insulating film recessed parts 160 and a plurality of gate pad recessed parts 121 may be provided continuously, and the well contact region 21 and the gate connection region 126 may be arranged in a nesting shape along one direction of the plane direction (Y direction in Fig. 1).

A width (length in the Y direction) of the well contact region 21 may be smaller than a width (length in the Y direction) of a part of the gate electrode 125 forming the gate electrode step part 125a. To describe using an aspect shown in Fig. 1 as an example, the width (length in the Y direction) of the well contact region 21 may be smaller than a width (length in the Y direction) of the gate electrode 125. As shown in Fig. 3, the drift layer 12 may be provided below the gate electrode 125 via the gate insulating film 60.

### <<Operations and Effects>>

Next, examples of operation and effect of the present embodiment having the above-described configuration will be described. Note that all aspects described in "Operation and Effects" can be adopted in the above-described configuration.

When in order to reduce a cell pitch, the same metal is used for the source region 31 that is an n-type semiconductor and the well contact region 21 that is a p-type semiconductor as the metal layer 40 shown in Fig. 3, in the case of a wide gap semiconductor material such as silicon carbide is used, it is inevitable that contact resistance to one of the source region 31 and the well contact region 21 becomes high. Since contact resistance to the source region 31 is directly linked to on-resistance similarly to the cell pitch, in order to reduce the on-resistance, it is desired to ensure reliability at the time of switching even under a condition that contact resistance to the well contact region 21 remains high.

It is known the concept of a propagation length in a case where contact resistance in a one-dimensional contact structure is evaluated by a transfer length method (TLM). A current flowing into a contact region is not uniform in a direction in which the contact region extends, and as the contact region goes closer to an end thereof into which the current flows, the current flowing into the contact region becomes higher, and in the contact region away from the end thereof into which the current flows, the current flowing into the contact region becomes small. Then, when the contact region is away at the propagation length or more from the end thereof into which the current flows, the flowing current can be ignored. Since there is no potential difference in metal wiring in the source pad 110 and the like, potential in the well contact region 21 that is a p-type region away at the propagation length or more from an end thereof into which a current flows is the same potential as potential of the metal wiring in the source pad 110 and the like, whereas as the well contact region 21 goes closer to the end thereof into which the current flows, the potential increases.

In the case of the wide gap semiconductor such as silicon carbide, the contact resistance to the well contact region 21 of the p-type may be high, and when a displacement current that charges a pn junction flows during switching, the potential of the entire well region 20 in a peripheral part increases. At this time, an electric field tends to concentrate in the gate insulating film step part 60a due to a three-dimensional shape of the gate insulating film step part 60a, and an excessive electric field may be applied, causing the gate insulating film step part 60a to be broken down.

As described above, as shown in Fig. 1, an aspect in which the field insulating film 62 has the field insulating film recessed part 160 extending in the plane direction and the well region 20 has the well contact region 21 where the well region 20 electrically connected to the source pad 110 provided in the field insulating film recessed part 160 is adopted. The adoption of the aspect is advantageous in that even if resistance in the well contact region 21 is high, an increase in the potential of the well region 20 of the p-type at a position below the gate insulating film step part 60a can be suppressed, and consequently the electric field can be prevented from being concentrated at the gate insulating film step part 60a.

Additionally, in a case where an aspect in which the well contact region 21 extends at a distance equal to or longer than the propagation length from the first boundary part 161 in the side of the source region 31 of the field insulating film 62 to the side opposite to the source region 31 is adopted, that is, in a case where an aspect in which the second boundary part 162 is formed in a region longer than the propagation length and the well contact region 21 extends at a length equal to or longer than the propagation length in a direction parallel to the second boundary part 162, the adoption of the aspect is advantageous in that that even if the resistance in the well contact region 21 is theoretically any value, an increase in the potential of the well region 20 of the p-type at the position below the gate insulating film step part 60a can be suppressed, and consequently the electric field can be prevented from being concentrated at the gate insulating film step part 60a.

### Second Embodiment

Next, a second embodiment of the present invention will be described.

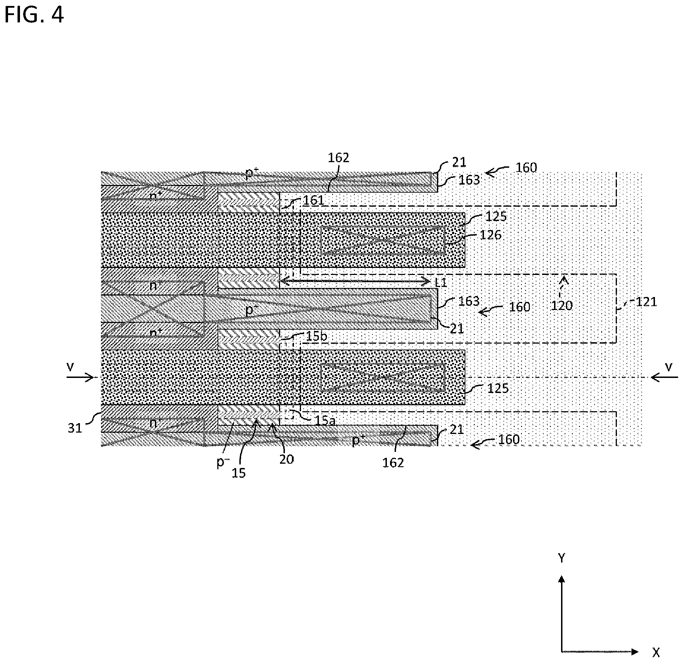

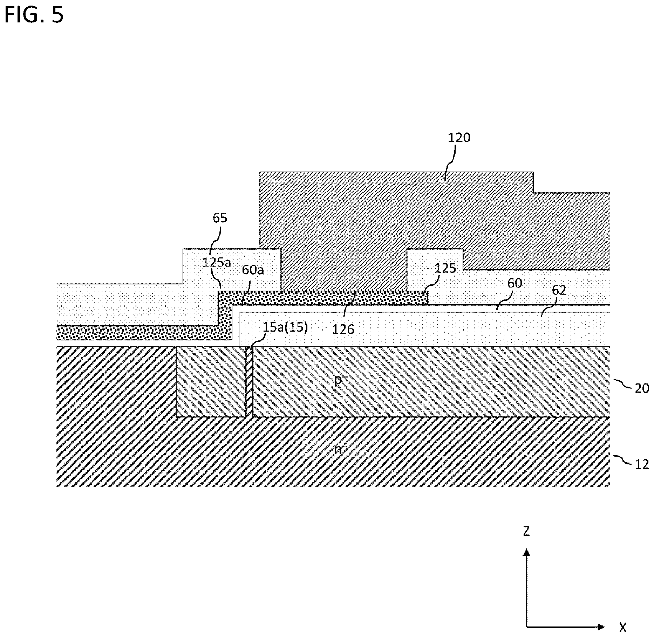

In the present embodiment, as shown in Fig. 4 and Fig. 5, a peripheral slit 15 reaching a drift layer 12 is provided in a well region 20 and in a side of a source region 31 than a gate contact hole (that is, closer to the side of the source region 31 than a gate connection region 126) in the plane direction. More specifically, the peripheral slit 15 has a first peripheral slit 15a extending along a Y direction while being connected to the drift layer 12 across the well region 20 provided below a field insulating film 62 (particularly see Fig. 5) and a second peripheral slit 15b provided at both ends of the first peripheral slit 15a and extending in an X direction while being connected to the drift layer 12 across the well region 20. Others are the same as those in the first embodiment, and any configuration adopted in the first embodiment can be adopted also in the second embodiment. Members described in the first embodiment will be described with the same reference numerals.

In an aspect shown in Fig. 4, the peripheral slit 15 is provided between well contact regions 21 in a plane direction, and a plurality of well contact regions 21 and a plurality of peripheral slits 15 are arranged in a nesting shape along a Y direction.

In order to apply the concept of a propagation length, it is advantageous that an arrangement is made so that a protruding shape of the well contact region 21 can be regarded as substantially one-dimensional. In this regard, by providing the peripheral slit 15 as in the present embodiment, a current from the well region 20 in a peripheral part of the well contact region 21 is forcibly directed to the well contact region 21, whereby an arrangement that can be regarded more as one-dimensional can be realized. As a result, there are advantages in that the above-described concept of the propagation length can be more reliably realized, an increase in potential of the well region 20 of a p-type at a position below a gate insulating film step part 60a can be more reliably suppressed, and consequently an electric field can be more reliably prevented from being concentrated at the gate insulating film step part 60a.

Note that also in the present embodiment, the adoption of an aspect in which the well contact region 21 extends at a distance equal to or longer than the propagation length from a first boundary part 161 in the side of the source region 31 of the field insulating film 62 to the side opposite to the source region 31 is advantageous from a viewpoint that the electric field can be prevented from being concentrated at the gate insulating film step part 60a.

### Third Embodiment

Next, a third embodiment of the present invention will be described.

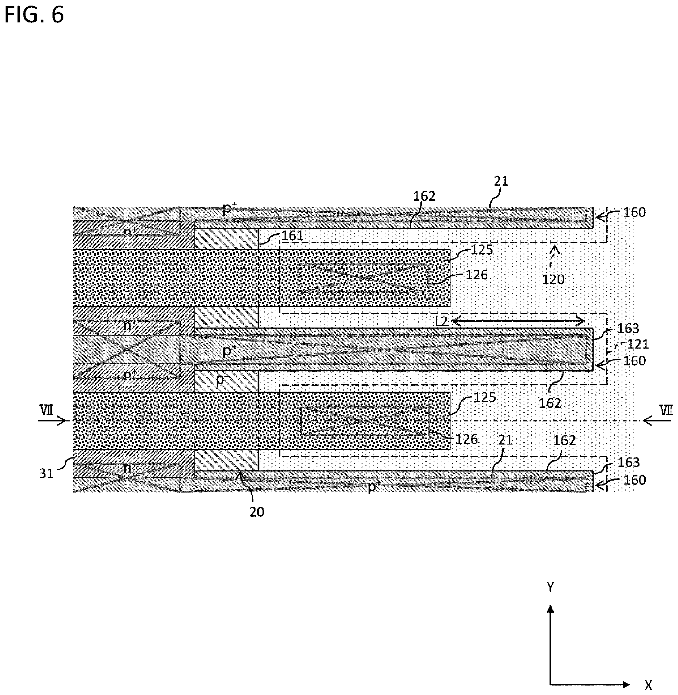

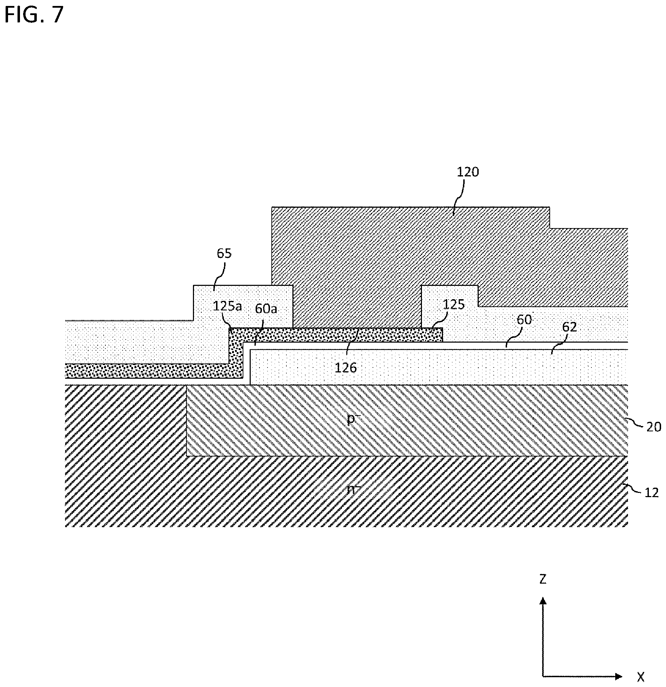

In the present embodiment, as shown in Fig. 6 and Fig. 7, a well contact region 21 extends to a side opposite to a source region 31 (the right side in Fig. 6) further than an end of a gate electrode 125 in the side opposite to the source region 31 (the left end of L2 shown by a double-headed arrow in Fig. 6). More specifically, the well contact region 21 extends to the right in an X direction further than the right end of the gate electrode 125 in the X direction in Fig. 6. Also in the present embodiment, any configuration adopted in each of the above embodiments can be adopted. Members described in the above embodiments will be described with the same reference numerals.

The adoption of an aspect like the present embodiment is advantageous in that even if resistance in the well contact region 21 is high, an increase in potential of a well region 20 of a p-type at a position below a gate insulating film step part 60a can be more reliably suppressed, and consequently an electric field can be prevented from being concentrated at the gate insulating film step part 60a.

Additionally, an aspect in which the well contact region 21 extends at a distance equal to or longer than a propagation length from the end of the gate electrode 125 in the side opposite to the source region 31 (the left end of L2 shown by the double-headed arrow in Fig. 6) to the side opposite to the source region 31 may be adopted. That is, an aspect in which a second distance L2 along the X direction from the end of the gate electrode 125 in the side opposite to the source region 31 to an end of the well contact region 21 in the side opposite to the source region 31 is longer than the propagation length may be adopted. In a case where this aspect is adopted, the adoption of the aspect is advantageous in that even if resistance in the well contact region 21 is high, an increase in the potential of the well region 20 of the p-type at the position below the gate insulating film step part 60a can be more reliably suppressed, and consequently the electric field can be further more reliably prevented from being concentrated at the gate insulating film step part 60a.

### Fourth Embodiment

Next, a fourth embodiment of the present invention will be described.

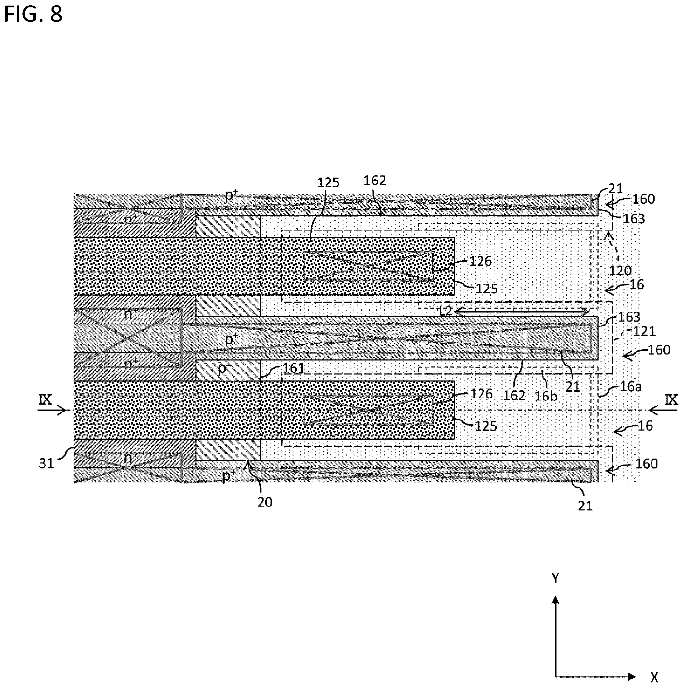

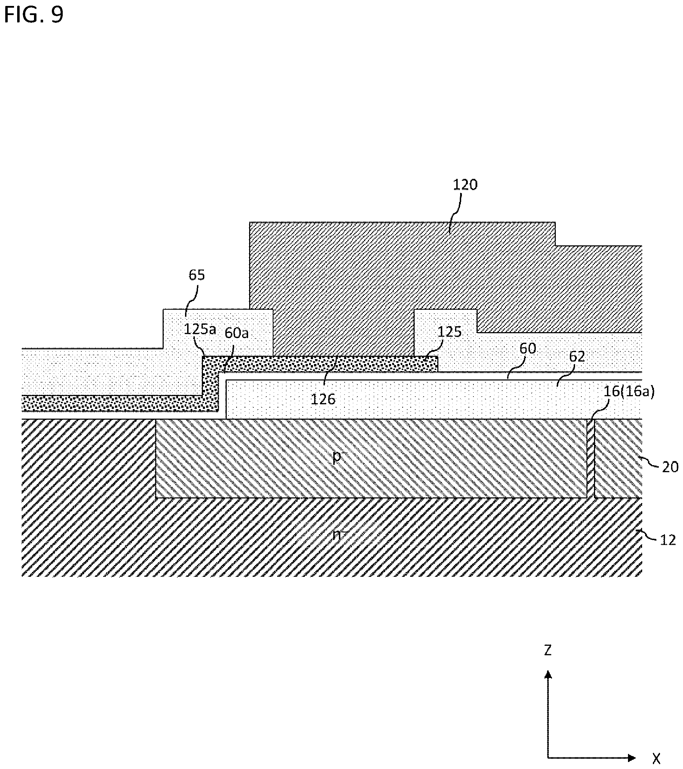

In the present embodiment, as shown in Fig. 8 and Fig. 9, an inner slit 16 reaching a drift layer 12 is provided in a side opposite to a source region 31 than a gate electrode 125 in a plane direction in a well region 20. More specifically, the inner slit 16 has a first inner slit 16a extending along a Y direction while being connected to the drift layer 12 across the well region 20 provided below a field insulating film 62 and a second inner slit 16b provided at both ends of the first inner slit 16a and extending in an X direction while being connected to the drift layer 12 across the well region 20. Others are the same as those in the third embodiment. Also in the present embodiment, any configuration adopted in each of the above embodiments can be adopted. Members described in the above embodiments will be described with the same reference numerals.

In an aspect shown in Fig. 8, the inner slit 16 is provided between well contact regions 21 in the plane direction, and a plurality of well contact regions 21 and a plurality of inner slits 16 are arranged in a nesting shape along the Y direction.

As described above, in order to apply the concept of a propagation length, it is advantageous that an arrangement is made so that a protruding shape of the well contact region 21 can be regarded as substantially one-dimensional. In this regard, by providing the inner slit 16 as in the present embodiment, a current from the well region 20 in a peripheral part of the well contact region 21 is forcibly directed to the well contact region 21, whereby an arrangement that can be regarded as one-dimensional can be realized. As a result, there are advantages in that the above-described concept of the propagation length can be more reliably realized, an increase in potential of the well region 20 of a p-type at a position below a gate insulating film step part 60a can be more reliably suppressed, and consequently an electric field can be more reliably prevented from being concentrated at the gate insulating film step part 60a.

Note that the second inner slit 16b may have a length equal to or longer than the propagation length.

Additionally, the second inner slit 16b may be longer than a second distance L2 along the X direction from an end of the gate electrode 125 in the side opposite to the source region 31 (the right end in Fig. 8) to an end of the well contact region 21 in the side opposite to the source region 31 (the right end in Fig. 8). In this case, an end of the second inner slit 16b on a side of the source region 31 (the left end in Fig. 8) may be positioned closer to the side of to the source region 31 (the left side in Fig. 8) than the end of the gate electrode 125 in the side opposite to the source region 31 (the right end in Fig. 8), and the end of the second inner slit 16b in the side of the source region 31 (the right end in Fig. 8) may be positioned in the side opposite to the source region 31 (the right in Fig. 8) than the end of the well contact region 21 in the side opposite to the source region 31 (the right side in Fig. 8).

The description of each embodiment, the description of the modification, and the disclosure of the drawings described above are merely examples for explaining the invention described in the claims, and the invention described in the claims is not limited by the description of the embodiment or the disclosure of the drawings described above. In addition, the recitation of the claims at the original application is merely an example, and the description of the claims can be appropriately changed based on the description of the specification, the drawings, and the like.

### Reference Signs List

- 12: Drift layer
- 15: Peripheral slit
- 15a: First peripheral slit
- 15b: Second peripheral slit
- 16: Inner slit
- 16a: First inner slit
- 16b: Second inner slit
- 20: Well region
- 21: Well contact region
- 31: Source region
- 60: Gate insulating film
- 62: Field insulating film
- 110: Source pad
- 120: Gate pad
- 125: Gate electrode
- 126: Gate connection region
- 160: Field insulating film recessed part (recessed part)
- 161: First boundary part
- 162: Second boundary part
- 163: Third boundary part

## Claims

1. A wide gap semiconductor device comprising:
a drift layer being a first conductivity type;
a well region being a second conductivity type and provided in the drift layer;
a source region provided in the well region;
a gate insulating film provided on the drift layer and the well region;
a gate electrode provided on the gate insulating film;
a gate pad electrically connected to the gate electrode; and
a field insulating film provided between a gate connection region, where the gate electrode and the gate pad are connected, and the well region, wherein
the field insulating film has a recessed part extending in a plane direction, and
the well region has a well contact region electrically connected to a source pad provided in the recessed part.

2. The wide gap semiconductor device according to claim 1,
wherein the well contact region extends at a distance equal to or longer than a propagation length from a first boundary part in a side of the source region of the field insulating film to a side opposite to the source region.

3. The wide gap semiconductor device according to claim 1, wherein
the gate electrode extends to a side opposite to the source region further than a first boundary part in a side of the source region of the field insulating film, and
the gate electrode and the gate pad are electrically connected to each other via a gate contact hole, provided in the side opposite to the source region than the first boundary part, in an interlayer insulating film.

4. The wide gap semiconductor device according to claim 3, wherein
a peripheral slit reaching the drift layer is provided in the well region and in a side of the source region than a gate contact hole in the plane direction.

5. The wide gap semiconductor device according to claim 4, wherein
the peripheral slit has a first peripheral slit extending along a first boundary part in the plane direction, and a second peripheral slit provided at an end of the first peripheral slit and extending in a direction orthogonal to the first boundary part in the plane direction.

6. The wide gap semiconductor device according to claim 3, wherein
the well contact region extends to the side opposite to the source region further than an end of the gate electrode in the side opposite to the source region.

7. The wide gap semiconductor device according to claim 6, wherein
the well contact region extends to the side opposite to the source region at a distance equal to or longer than a propagation length from the end of the gate electrode in the side opposite to the source region.

8. The wide gap semiconductor device according to claim 6, wherein
an inner slit reaching the drift layer is provided in the well region and in a side opposite to the source region than the gate electrode in the plane direction.

9. The wide gap semiconductor device according to claim 8, wherein the inner slit has a second inner slit extending to the side opposite to the source region at a distance equal to or longer than a propagation length from the end of the gate electrode in the side opposite to the source region.
